(19) Europäisches Patentamt
European Patent Office
Office européen des brevets

(11) **EP 4 779 062 A1**

(12) **EUROPÄISCHE PATENTANMELDUNG**

(43) Veröffentlichungstag:
   **22.07.2026 Patentblatt 2026/30**

(21) Anmeldenummer: **25152093.8**

(22) Anmeldetag: **15.01.2025**

(51) Internationale Patentklassifikation (IPC):
   **C30B 23/00** (2006.01)   **C30B 23/06** (2006.01)
   **C30B 29/36** (2006.01)

(52) Gemeinsame Patentklassifikation (CPC):
   **C30B 29/36; C30B 23/002; C30B 23/06**

(84) Benannte Vertragsstaaten:
   **AL AT BE BG CH CY CZ DE DK EE ES FI FR GB GR HR HU IE IS IT LI LT LU LV MC ME MK MT NL NO PL PT RO RS SE SI SK SM TR**
   Benannte Erstreckungsstaaten:
   **BA**
   Benannte Validierungsstaaten:
   **GE KH MA MD TN**

(71) Anmelder: **SiCrystal GmbH**
   **90411 Nürnberg (DE)**

(72) Erfinder:
   • **Ecker, Bernhard**
     **90411 Nürnberg (DE)**
   • **Elitzer, Daniel**
     **90411 Nürnberg (DE)**
   • **Vogel, Michael**
     **90411 Nürnberg (DE)**
   • **Wohlfart, Andreas**
     **90411 Nürnberg (DE)**

(74) Vertreter: **Rau, Schneck & Hübner**
   **Patentanwälte Rechtsanwälte PartGmbB**
   **Königstraße 2**
   **90402 Nürnberg (DE)**

(54) **HERSTELLUNGSVERFAHREN FÜR EINEN SIC-VOLUMENEINKRISTALL MIT TEMPERUNGS-ABKÜHLPHASE UND EINKRISTALLINER KREISZYLINDRISCHER SIC-GRUNDKÖRPER**

(57) Das Verfahren ist zur Herstellung mindestens eines SiC-Volumeneinkristalls (24) mittels einer Sublimationszüchtung bestimmt. Vor dem Züchtungsbeginn wird in mindestens einem Kristallwachstumsbereich (5) eines Züchtungstiegels (3) mindestens ein SiC-Keimkristall (8) angeordnet, und wird in einen SiC-Vorratsbereich (4) des Züchtungstiegels (3) SiC-Quellmaterial (6) eingebracht. Während einer Züchtungsphase wird mittels Sublimation des SiC-Quellmaterials (6) und mittels Transport der sublimierten gasförmigen Komponenten in den mindestens einen Kristallwachstumsbereich (5) dort eine SiC-Wachstumsgasphase (9) erzeugt, und wächst der mindestens eine eine zentrale Kristallmittenlängsachse (14) aufweisende SiC-Volumeneinkristall (24) mittels Abscheidung aus der SiC-Wachstumsgasphase (9) auf dem mindestens einen SiC-Keimkristall (8) auf. Während einer nach Abschluss der Züchtungsphase in dem Züchtungstiegel durchgeführten Temperungs-Abkühlphase wird der zuvor gezüchtete mindestens eine SiC-Volumeneinkristall (24) abgekühlt, wobei innerhalb des mindestens einen SiC-Volumeneinkristalls (24) ein in Richtung der zentralen Kristallmittenlängsachse (14) gemessener axialer Abkühlungs-Temperaturgradienten vorgesehen wird, und ein axialer Quotient zwischen dem axialen Abkühlungs-Temperaturgradienten und einem am Ende der vorangegangenen Züchtungsphase innerhalb des mindestens einen aufgewachsenen SiC-Volumeneinkristalls (24) herrschenden und ebenfalls in Richtung der zentralen Kristallmittenlängsachse (14) gemessenen axialen Züchtungs-Temperaturgradienten höchstens einen axialen Vergleichswert von 0,4 hat.

Fig. 2

## Beschreibung

Die Erfindung betrifft ein Verfahren zur Herstellung mindestens eines SiC-Volumeneinkristalls mittels einer Sublimationszüchtung sowie einen einkristallinen SiC-Grundkörper.

Das Halbleitermaterial Siliziumcarbid (SiC) wird aufgrund seiner herausragenden physikalischen, chemischen, elektrischen und optischen Eigenschaften unter anderem auch als Ausgangsmaterial für leistungselektronische Halbleiterbauelemente, für Hochfrequenzbauelemente und für spezielle lichtgebende Halbleiterbauelemente eingesetzt. Für diese Bauelemente werden SiC-Substrate (= SiC-Wafer) mit möglichst großem Substratdurchmesser und möglichst hoher Qualität benötigt.

Basis für die SiC-Substrate sind hochwertige SiC-Volumeneinkristalle, die in der Regel mittels physikalischer Gasphasenabscheidung (PVT) hergestellt werden, insbesondere mittels eines z.B. in der US 8,865,324 B2 beschriebenen (Sublimations-)Verfahrens. Bei diesem Züchtungsverfahren wird eine einkristalline SiC-Scheibe als SiC-Keimkristall zusammen mit geeignetem Quellmaterial in einen Züchtungstiegel eingebracht. Unter kontrollierten Temperatur- und Druckbedingungen wird das Quellmaterial sublimiert und die gasförmigen Spezies scheiden sich auf dem SiC-Keimkristall ab, so dass der SiC-Volumeneinkristall dort aufwächst.

Aus dem SiC-Volumeneinkristall werden anschließend z.B. mit Hilfe einer Fadensäge oder eines ähnlichen Verfahrens scheibenförmige einkristalline SiC-Substrate herausgeschnitten, die nach einer mehrstufigen veredelnden Bearbeitung ihrer Oberfläche, insbesondere mittels mehrerer Polierschritte, im Rahmen der Bauelementefertigung mit mindestens einer dünnen einkristallinen Epitaxieschicht z.B. aus SiC oder GaN (Galliumnitrid) versehen werden. In der Regel werden Defekte aus dem SiC-Substrat in die aufgebrachte Epitaxieschicht vererbt. Die Eigenschaften der Epitaxieschicht und damit letztlich auch die der daraus hergestellten Bauelemente hängen entscheidend von der Qualität des SiC-Substrats bzw. des zugrundeliegenden SiC-Volumeneinkristalls ab.

Die Qualität des SiC-Substrats hängt unter anderem auch von den Spannungen ab, die während der Kristallzüchtung auf den SiC-Volumeneinkristall einwirken. Diese Spannungen können dazu führen, dass die aus dem SiC-Volumeneinkristall gefertigten SiC-Substrate eine Verbiegung bzw. Durchbiegung (engl.: bow) und/oder eine Krümmung bzw. Wölbung (engl.: warp) aufweisen, was dann geringere Qualität bzw. geringere Ausbeute des Epitaxie-Prozesses zur Folge hat.

Deshalb werden SiC-Volumeneinkristalle nach ihrer Züchtung üblicherweise einer thermischen Nachbehandlung (= Temperung) unterzogen, um Spannungen innerhalb des SiC-Kristallgitters auszuheilen oder zumindest zu reduzieren und somit die Kristallqualität zu verbessern. Ein solches thermisches Nachbehandlungsverfahren wird beispielsweise in der DE 10 2009 048 868 B4 beschrieben. Der SiC-Volumeneinkristall wird nach seiner Züchtung während eines nachgelagerten zusätzlichen Prozessschrittes in einem gesonderten Temperungstiegel getempert, wobei er vollständig in SiC-Pulver eingebettet ist. Während der thermischen Nachbehandlung liegt im SiC-Volumeneinkristall ein möglichst isothermes bzw. homogenes Temperaturfeld vor. Vorzugsweise wird ein in Richtung der Kristallmittenlängsachse des SiC-Volumeneinkristalls gemessener (= axialer) möglichst niedriger Temperaturunterschied von höchstens 2 K eingestellt, um einen Ausgleich mechanischer Spannungen in axialer Richtung zu begünstigen.

In der US 8,449,671 B2 wird ein weiteres Verfahren zur thermischen Nachbehandlung eines SiC-Volumeneinkristalls beschrieben, das ebenfalls zur Reduzierung von Spannungen innerhalb des SiC-Kristallgitters führen soll. Während dieser ebenfalls in einem gesonderten Temperungstiegel durchgeführten Nachbehandlung wird der SiC-Volumeneinkristall mit einem axialen Temperaturgradienten beaufschlagt, der gegensinnig zu dem während der vorangegangenen eigentlichen Kristallzüchtung eingestellten axialen Temperaturgradienten ist.

Die bislang zur Ausheilung von Spannungen im SiC-Kristallgitter übliche zusätzliche thermische Nachbehandlung in einem gesonderten Temperungstiegel ist teuer und aufwendig.

Die Aufgabe der Erfindung besteht darin, ein gegenüber den bekannten Lösungen verbessertes Verfahren zur Herstellung eines SiC-Volumeneinkristalls sowie einen verbesserten einkristallinen SiC-Grundkörper anzugeben.

Zur Lösung der das Verfahren betreffenden Aufgabe wird ein Verfahren entsprechend den Merkmalen des Patentanspruchs 1 angegeben. Bei dem erfindungsgemäßen Verfahren handelt es sich um ein solches zur Herstellung mindestens eines SiC-Volumeneinkristalls mittels einer Sublimationszüchtung, wobei vor dem Züchtungsbeginn in mindestens einem Kristallwachstumsbereich eines Züchtungstiegels mindestens ein SiC-Keimkristall angeordnet wird, und in einen SiC-Vorratsbereich des Züchtungstiegels SiC-Quellmaterial eingebracht wird, während einer Züchtungsphase mittels Sublimation des SiC-Quellmaterials und mittels Transport der sublimierten gasförmigen Komponenten in den mindestens einen Kristallwachstumsbereich dort eine SiC-Wachstumsgasphase erzeugt wird, und der mindestens eine eine zentrale Kristallmittenlängsachse aufweisende SiC-Volumeneinkristall mittels Abscheidung aus der SiC-Wachstumsgasphase auf dem mindestens einen SiC-Keimkristall aufwächst, und während einer nach Abschluss der Züchtungsphase in dem Züchtungstiegel durchgeführten Temperungs-Abkühlphase der zuvor gezüchtete mindestens eine SiC-Volumeneinkristall abgekühlt wird, wobei innerhalb des mindestens einen SiC-Volumeneinkristalls ein in Richtung der zentralen Kristallmittenlängsachse gemessener axialer Abkühlungs-Temperaturgradienten vorgesehen wird, und ein axialer Quotient zwischen dem axialen Abkühlungs-Temperaturgradienten und einem am Ende der vorangegangenen Züchtungsphase innerhalb des mindestens einen aufgewachsenen SiC-Volumeneinkristalls herrschenden und ebenfalls in Richtung der zentralen Kristallmittenlängsachse gemessenen axialen Züchtungs-Temperaturgradienten höchstens einen axialen Vergleichswert von 0,4 hat.

Der axiale Abkühlungs-Temperaturgradient (grad T)$_{ax\_abk}$ und der axiale Züchtungs-Temperaturgradienten (grad T)$_{ax\_zücht}$ sind jeweils die erste mathematische Ableitung der betreffenden Temperatur nach der Ortskoordinate in Richtung der zentralen Kristallmittenlängsachse, also nach der axialen Ortskoordinate. Der axiale Abkühlungs-Temperaturgradient (grad T)$_{ax\_abk}$ ist insbesondere der Dividend des axialen Quotienten, und der axiale Züchtungs-Temperaturgradienten (grad T)$_{ax\_zücht}$ insbesondere der Divisor. Es gilt also:

$$\frac{(\mathrm{grad\,T})_{ax\_abk}}{(\mathrm{grad\,T})_{ax\_zücht}} \leq 0{,}4 \qquad\qquad (1a)$$

oder

$$(\mathrm{grad\,T})_{ax\_abk} \leq 0{,}4 \cdot (\mathrm{grad\,T})_{ax\_zücht} \qquad\qquad (1b)$$

Mit anderen Worten ausgedrückt, beträgt der axiale Abkühlungs-Temperaturgradient (grad T)$_{ax\_abk}$ höchstens 40 % des am Ende der vorangegangenen Züchtungsphase innerhalb des mindestens einen aufgewachsenen SiC-Volumeneinkristalls herrschenden axialen Züchtungs-Temperaturgradienten (grad T)$_{ax\_zücht}$. Der axiale Abkühlungs-Temperaturgradient (grad T)$_{ax\_abk}$ und der mit ihm zu vergleichende axiale Züchtungs-Temperaturgradient (grad T)$_{ax\_zücht}$ liegen dabei insbesondere jeweils an der gleichen Stelle innerhalb des mindestens einen SiC-Volumeneinkristalls vor. Die angesprochene Beziehung zwischen dem axialen Abkühlungs-Temperaturgradienten (grad T)$_{ax\_abk}$ und dem axialen Züchtungs-Temperaturgradienten (grad T)$_{ax\_zücht}$ gilt außerdem vorzugsweise auch an jeder Stelle innerhalb des mindestens einen SiC-Volumeneinkristalls.

Während seiner Züchtung ist der mindestens eine SiC-Volumeneinkristall in axialer Richtung aufgewachsen. Mit "axial" ist im Zusammenhang mit dem erfindungsgemäßen Verfahren eine Richtung parallel zur oder längs der zentralen Kristallmittenlängsachse, mit "radial" eine dazu senkrechte Richtung und mit "tangential" eine um die Kristallmittenlängsachse umlaufende Umfangsrichtung bezeichnet.

Es wurde erkannt, dass die Qualität eines später aus dem mindestens einen SiC-Volumeneinkristall gewonnenen SiC-Substrats unter anderem auch von Spannungen abhängt, die während des Kristallzüchtungsprozesses auf den SiC-Volumeneinkristall einwirken können, und zwar nicht nur während der eigentlichen Züchtungsphase, sondern auch erst während der Abkühlphase, während der der gewachsene SiC-Volumeneinkristall in dem Züchtungstiegel abgekühlt wird, insbesondere auf Raumtemperatur. Diese Spannungen können zu Verbiegungen (engl.: bow) und/oder Krümmungen (engl.: warp) der aus dem SiC-Volumeneinkristall gefertigten SiC-Substrate führen und/oder auch zu Versetzungen innerhalb des SiC-Kristallgitters. Jeder dieser Effekte schmälert die Qualität eines SiC-Substrats. Insbesondere können Versetzungen in der Basalebene (BPD=basal plane dislocation) entstehen, die sich durch die Relaxation von Spannungen innerhalb des SiC-Kristallgitters des gewachsenen SiC-Volumeneinkristalls z.B. während der Abkühlphase bilden können.

Es gibt verschiedene Ursachen für Spannungen im SiC-Kristallgitter, so beispielsweise die zur Züchtung verwendete Einheit aus dem SiC-Keimkristall und dem zugehörigen Keim-Halter oder unterschiedliche thermische Ausdehnungskoeffizienten der Wand des Züchtungstiegels und des der Wand gegenüberliegenden und insbesondere an ihr anliegenden seitlichen Umfangsrandes des SiC-Volumeneinkristalls oder die für das Kristallwachstum während der eigentlichen Züchtungsphase notwendigen Temperaturgradienten oder eben auch die während der Abkühlphase vorherrschenden Temperaturgradienten, welche hier im Fokus stehen. Diesbezüglich wird während der Temperungs-Abkühlphase nach Züchtungsende insbesondere eine Reduzierung der bislang üblichen Temperaturgradienten vorgenommen. Vorzugsweise werden niedrigere Temperaturgradienten als bislang üblich eingestellt.

Bei dem zur Züchtung des mindestens einen SiC-Volumeneinkristalls angewendeten physikalischen Gasphasenabscheidungsverfahren (= PVT-Verfahren) wird das verdampfte SiC-Quellmaterial mittels eines axialen Temperaturgradienten hin zum SiC-Keimkristall bzw. hin zum aufwachsenden SiC-Volumeneinkristall transportiert, wo es abgeschieden wird und als einkristallines Material aufwächst. Bei fortschreitender Züchtungsdauer verändert sich der Abstand des SiC-Quellmaterials zur Wachstumsgrenzfläche des aufwachsenden SiC-Volumeneinkristalls. Daraus resultiert eine axiale Änderung des Temperaturfeldes innerhalb des SiC-Volumeneinkristalls entlang seiner Wachstumsrichtung, was zu Spannungen innerhalb des SiC-Volumeneinkristalls führen kann.

Ebenso wird ein radialer Temperaturgradient eingestellt, der die Wachstumsgrenzfläche des wachsenden Kristalls definiert. Am Rand des aufwachsenden SiC-Volumeneinkristalls wird eine höhere Temperatur eingestellt als in der Kristallmitte, insbesondere um Einwüchse vom Rand zu vermeiden. Der SiC-Volumeneinkristall wächst somit in Mitte etwas schneller als an seinem Rand.

Sowohl der axiale als auch der radiale Temperaturgradient sind für die Züchtung von SiC-Volumeneinkristallen im PVT-Verfahren notwendig. Allerdings haben beide Temperaturgradienten nicht nur die gewünschten positiven Effekte, sondern auch negative Einflüsse auf die Qualität der gewachsenen SiC-Volumeneinkristalle und der daraus gefertigten SiC-Substrate. Ein aus einem SiC-Volumeneinkristall herausgetrenntes SiC-Substrat besteht, bezogen auf die Wachstumsgrenzfläche des SiC-Volumeneinkristalls, aus zu unterschiedlichen Zeitpunkten gewachsenen Bereichen des SiC-Volumeneinkristalls. Insgesamt ist der wachsende SiC-Volumeneinkristall einem sich stetig ändernden Temperaturprofil ausgesetzt, wodurch sich der Spannungshaushalt im SiC-Kristallgitter erhöhen kann. Außerdem können bei den während der Kristallzüchtung herrschenden hohen Temperaturen Umlagerungsprozesse im SiC-Kristallgitter stattfinden, die durch Gitterspannungen verursacht werden und zur Bildung von Versetzungen, insbesondere von Basalebenenversetzungen, führen.

Nach Abschluss der eigentlichen Züchtungsphase wird die gesamte Züchtungsanordnung inklusive des im Züchtungstiegel befindlichen zuvor gezüchteten mindestens einen SiC-Volumeneinkristalls auf Raumtemperatur abgekühlt, bevor der SiC-Volumeneinkristall entnommen werden kann. Während des Abkühlprozesses werden große Wärmemengen in axialer Richtung und radialer Richtung von der Züchtungsanordnung nach außen hin abgegeben. Auch über den mindestens einen SiC-Volumeneinkristall hinweg erfolgt eine Abfuhr von Wärme in axialer und radialer Richtung. Während des Abkühlprozesses können bis zu einer gewissen Temperatur noch Spannungen entstehen, umgelagert werden oder auch in Versetzungen, insbesondere in Basalebenenversetzungen, umgewandelt werden.

Es wurde erkannt, dass ein Abkühlen des mindestens einen SiC-Volumeneinkristalls mit einem axialen Abkühlungs-Temperaturgradienten $(\mathrm{grad\,T})_{\mathrm{ax\_abk}}$ von höchstens 40 % des am Ende der vorangegangenen Züchtungsphase innerhalb des mindestens einen aufgewachsenen SiC-Volumeneinkristalls herrschenden axialen Züchtungs-Temperaturgradienten $(\mathrm{grad\,T})_{\mathrm{ax\_zücht}}$ dazu führt, dass der mindestens eine SiC-Volumeneinkristall über seine gesamte axiale Länge vorzugsweise einen homogenisierten und insbesondere außerdem auch niedrigen Spannungshaushalt sowie einen ebenfalls homogenisierten und insbesondere außerdem auch niedrigen Basalebenenversetzungshaushalt aufweist. Das erfindungsgemäße Verfahren weist während der Abkühlphase vorzugsweise eine spannungs- und versetzungsmindernde "in-situ"-Temperung, d.h. eine nach Züchtungsende noch im Züchtungstiegel durchgeführte Temperung, auf. Es resultiert ein hochwertiger SiC-Volumeneinkristall, aus dem hochwertige SiC-Substrate mit einem geringen Grad an Verbiegung (Bow), Krümmung (Warp) und Basalebenenversetzungen gefertigt werden können. Diese vorteilhaften Effekte ergeben sich insbesondere, ohne dass eine zusätzliche thermische Nachbehandlung in einem gesonderten Temperungstiegel durchgeführt wird. Die erfindungsgemäße Temperungs-Abkühlphase mit dem genannten niedrigen axialen Abkühlungs-Temperaturgradienten $(\mathrm{grad\,T})_{\mathrm{ax\_abk}}$ und der insbesondere daraus resultierenden langsamen Abkühlrate kann also vorteilhafterweise eine zusätzliche thermische Behandlung in einem nachgelagerten Prozess ersetzen. Die Zeitspanne zum Abkühlen von der Züchtungstemperatur auf die Raumtemperatur ist bei der Temperungs-Abkühlphase mit dem genannten niedrigen axialen Abkühlungs-Temperaturgradienten $(\mathrm{grad\,T})_{\mathrm{ax\_abk}}$ insbesondere mindestens 20%, vorzugsweise mindestens 30%, länger als eine herkömmliche Abkühlzeit ohne Einstellung des genannten niedrigen axialen Abkühlungs-Temperaturgradienten $(\mathrm{grad\,T})\mathrm{ax}_{\_\mathrm{abk}}$.

Das erfindungsgemäße Verfahren ist aufgrund der "in situ"-Temperung des mindestens einen aufgewachsenen SiC-Volumeneinkristalls während der Abkühlphase sehr effizient und zugleich kostengünstiger als die bislang üblichen zusätzlichen thermischen Nachbehandlungen in gesonderten Temperungstiegeln. Das erfindungsgemäße Verfahren erlaubt insbesondere die Herstellung eines einzigen SiC-Volumeneinkristalls, vorzugsweise aber auch die gleichzeitige Herstellung von zwei oder drei oder vier oder fünf oder sechs oder sieben oder acht oder neun oder zehn oder auch noch mehr SiC-Volumeneinkristallen.

Vorteilhafte Ausgestaltungen des erfindungsgemäßen Verfahrens ergeben sich aus den Merkmalen der von Anspruch 1 abhängigen Ansprüche.

Günstig ist eine Ausgestaltung, bei der der axiale Abkühlungs-Temperaturgradient so vorgesehen wird, dass der axiale Quotient zwischen dem axialen Abkühlungs-Temperaturgradienten und dem am Ende der vorangegangenen Züchtungsphase innerhalb des mindestens einen aufgewachsenen SiC-Volumeneinkristalls herrschenden axialen Züchtungs-Temperaturgradienten höchstens einen axialen Vergleichswert von 0,3 hat. Es gilt also:

$$\frac{(\mathrm{grad\,T})_{\mathrm{ax\_abk}}}{(\mathrm{grad\,T})_{\mathrm{ax\_zücht}}} \leq 0{,}3 \qquad\qquad (2a)$$

oder

$$(\mathrm{grad\,T})_{\mathrm{ax\_abk}} \leq 0{,}3\cdot(\mathrm{grad\,T})_{\mathrm{ax\_zücht}}) \qquad\qquad (2b)$$

Anders ausgedrückt beträgt der axiale Abkühlungs-Temperaturgradient $(\mathrm{grad\,T})_{\mathrm{ax\_abk}}$ höchstens 30 % des am Ende der vorangegangenen Züchtungsphase innerhalb des mindestens einen aufgewachsenen SiC-Volumeneinkristalls herrschenden axialen Züchtungs-Temperaturgradienten (grad T)$_{ax\_zücht}$. Aufgrund des noch niedrigeren axialen Abkühlungs-Temperaturgradienten (grad T)$_{ax\_abk}$ und der daraus resultierenden noch längeren Dauer der Temperungs-Abkühlphase werden die im Kristallgitter des mindestens einen SiC-Volumeneinkristalls am Ende der Temperungs-Abkühlphase vorhandenen Spannungen und Versetzungen, insbesondere Basalebenenversetzungen, weiter reduziert und auch homogenisiert. Der so resultierende mindestens eine SiC-Volumeneinkristall und die aus ihm hergestellten SiC-Substrate sind dann noch hochwertiger.

Gemäß einer weiteren günstigen Ausgestaltung wird der axiale Abkühlungs-Temperaturgradient so vorgesehen, dass der axiale Quotient zwischen dem axialen Abkühlungs-Temperaturgradienten und dem axialen Züchtungs-Temperaturgradienten in jedem 1 cm$^3$ großen Teilvolumen innerhalb des mindestens einen SiC-Volumeneinkristalls höchstens den axialen Vergleichswert hat. Dies fördert die Homogenisierung des Spannungshaushalts sowie des (Basalebenen-)Versetzungshaushalts weiter. Die Vergleichsbedingung zwischen dem axialen Abkühlungs-Temperaturgradienten (grad T)$_{ax\_abk}$ und dem axialen Züchtungs-Temperaturgradienten (grad T)$_{ax}$zücht:

$$(\mathrm{grad\ T})_{ax\_abk} \leq C_{ax\_max} \cdot (\mathrm{grad\ T})_{ax\_zücht} \qquad\qquad (3)$$

ist insbesondere überall innerhalb des mindestens einen SiC-Volumeneinkristalls erfüllt, wobei C$_{ax\_max}$ für den axialen Vergleichswert des axialen Quotienten steht, der insbesondere 0,4 oder 0,3 beträgt.

Gemäß einer weiteren günstigen Ausgestaltung wird der axiale Abkühlungs-Temperaturgradient so vorgesehen, dass er mindestens 2 K/cm, und insbesondere höchstens 6 K/cm beträgt. So niedrige Werte des axialen Abkühlungs-Temperaturgradienten sind besonders günstig für eine gute Temperungswirkung während der Temperungs-Abkühlphase.

Gemäß einer weiteren günstigen Ausgestaltung wird während der Temperungs-Abkühlphase ein senkrecht zu der zentralen Kristallmittenlängsachse gemessener radialer Abkühlungs-Temperaturgradient innerhalb des mindestens einen SiC-Volumeneinkristalls vorgesehen, und ein radialer Quotient zwischen dem radialen Abkühlungs-Temperaturgradienten und einem am Ende der vorangegangenen Züchtungsphase innerhalb des mindestens einen aufgewachsenen SiC-Volumeneinkristalls herrschenden und ebenfalls senkrecht zu der zentralen Kristallmittenlängsachse gemessenen radialen Züchtungs-Temperaturgradienten höchstens einen radialen Vergleichswert von 0,4, und insbesondere höchstens einen radialen Vergleichswert von 0,3, hat. Der radiale Abkühlungs-Temperaturgradient (grad T)$_{rad\_abk}$ und der radiale Züchtungs-Temperaturgradienten (grad T)$_{rad\_zücht}$ sind jeweils die erste mathematische Ableitung der betreffenden Temperatur nach der Ortskoordinate senkrecht zur zentralen Kristallmittenlängsachse, also nach der radialen Ortskoordinate. Der radiale Abkühlungs-Temperaturgradient (grad T)$_{rad\_abk}$ ist insbesondere der Dividend des radialen Quotienten, und der radiale Züchtungs-Temperaturgradienten (grad T)$_{rad\_zücht}$ insbesondere der Divisor. Es gilt also:

$$\frac{(\mathrm{grad\ T})_{rad\_abk}}{(\mathrm{grad\ T})_{rad\_zücht}} \leq C_{rad\_max} \qquad\qquad (4a)$$

oder

$$(\mathrm{grad\ T})_{rad\_abk} \leq C_{rad\_max} \cdot (\mathrm{grad\ T})_{rad\_zücht} \qquad\qquad (4b)$$

wobei C$_{rad\_max}$ für den radialen Vergleichswert des radialen Quotienten steht, der insbesondere 0,4 oder bevorzugt 0,3 beträgt. Anders ausgedrückt beträgt der radiale Abkühlungs-Temperaturgradient (grad T)$_{rad\_abk}$ höchstens 40 %, insbesondere höchstens 30 % des am Ende der vorangegangenen Züchtungsphase innerhalb des mindestens einen aufgewachsenen SiC-Volumeneinkristalls herrschenden radialen Züchtungs-Temperaturgradienten (grad T)$_{rad\_zücht}$. Der radiale Abkühlungs-Temperaturgradient (grad T)$_{rad\_abk}$ und der mit ihm zu vergleichende radiale Züchtungs-Temperaturgradient (grad T)$_{rad\_zücht}$ liegen dabei insbesondere jeweils an der gleichen Stelle innerhalb des mindestens einen SiC-Volumeneinkristalls vor.

Die angesprochene Beziehung zwischen dem radialen Abkühlungs-Temperaturgradienten (grad T)$_{rad\_abk}$ und dem radialen Züchtungs-Temperaturgradienten (grad T)$_{rad\_zücht}$ gilt außerdem vorzugsweise auch an jeder Stelle innerhalb des mindestens einen SiC-Volumeneinkristalls. Auch der niedrige radiale Abkühlungs-Temperaturgradient (grad T)$_{rad\_abk}$ trägt dazu bei, dass die im Kristallgitter des mindestens einen SiC-Volumeneinkristalls am Ende der Temperungs-Abkühlphase vorhandenen Spannungen und Versetzungen, insbesondere Basalebenenversetzungen, weiter reduziert und auch homogenisiert werden. Der so resultierende mindestens eine SiC-Volumeneinkristall und die aus ihm hergestellten SiC-Substrate sind dann besonders hochwertig.

Gemäß einer weiteren günstigen Ausgestaltung wird der radiale Abkühlungs-Temperaturgradient so vorgesehen wird, dass der radiale Quotient zwischen dem radialen Abkühlungs-Temperaturgradienten und dem radialen Züchtungs-Temperaturgradienten in jedem 1 cm$^3$ großen Teilvolumen innerhalb des mindestens einen SiC-Volumeneinkristalls höchstens den radialen Vergleichswert hat. Dies fördert die Homogenisierung des Spannungshaushalts sowie des (Basalebenen-)Versetzungshaushalts weiter. Die Vergleichsbedingung zwischen dem radialen Abkühlungs-Temperaturgradienten (grad T)$_{rad\_abk}$ und dem radialen Züchtungs-Temperaturgradienten (grad T)$_{rad\_zücht}$ gemäß der vorstehenden Gleichung (4a) oder (4b) ist insbesondere überall innerhalb des mindestens einen SiC-Volumeneinkristalls erfüllt.

Gemäß einer weiteren günstigen Ausgestaltung wird der radiale Abkühlungs-Temperaturgradient so vorgesehen, dass er mindestens 0,25 K/cm, und insbesondere höchstens 2 K/cm beträgt. So niedrige Werte des radialen Abkühlungs-Temperaturgradienten sind besonders günstig für eine gute Temperungswirkung während der Temperungs-Abkühlphase.

Gemäß einer weiteren günstigen Ausgestaltung wird für den mindestens einen SiC-Volumeneinkristall eine längs der zentralen Kristallmittenlängsachse gemessene zentrale Kristalllänge von 30 mm bis 60 mm, insbesondere von 35 mm bis 50 mm, vorgesehen.

Gemäß einer weiteren günstigen Ausgestaltung wird nach Abschluss der Züchtungsphase als Maßnahme zur Reduzierung von Spannungen innerhalb des zuvor gezüchteten mindestens einen SiC-Volumeneinkristalls die vorher verwendete Züchtungsanordnung verändert, indem eine zusätzliche Abdeckung stirnseitig benachbart zu einer den Züchtungstiegel umgebenden Züchtungsisolation und insbesondere auf der von dem Züchtungstiegel abgewandten Seite der Züchtungsisolation platziert wird. Insbesondere wird die zusätzliche Abdeckung dabei manuell oder automatisiert gesteuert an die gewünschte Position gebracht. Vorzugsweise ist ein entsprechender Steuerungs- und Verstellmechanismus vorgesehen. Das Material der zusätzlichen Abdeckung kann insbesondere das gleiche Material wie bei der Züchtungsisolation sein, beispielsweise ein Isolationsmaterial aus oder mit Kohlenstofffilz, der aus Kohlenstofffasern hergestellt ist, oder ein Isolationsmaterial aus oder mit einem schaumartigen und/oder porösen Kohlenstoff-Kompositmaterial vorzugsweise mit einer schaumartigen und/oder porösen Kohlenstoffmatrix mit darin eingebetteten Kohlenstofffasern. Die zusätzliche Abdeckung wird insbesondere als ein thermisch isolierendes Element ausgebildet. Die Dicke der zusätzlichen Abdeckung liegt insbesondere zwischen 10 mm und 100 mm. Dabei ist die Dicke gleich der Ausdehnung in axialer Richtung. Die zusätzliche Abdeckung hat insbesondere eine Grundform in Gestalt einer vorzugsweise zylindrischen Platte. Die für die Temperungs-Abkühlphase eingebrachte zusätzliche Abdeckung bewirkt insbesondere aufgrund ihrer zusätzlichen thermischen Isolation vorteilhafterweise eine Einstellung der axialen und/oder radialen Abkühlungs-Temperaturgradienten auf die gewünschten niedrigen Werte. Die zusätzliche Abdeckung ist eine einfach zu bewerkstelligende, aber trotzdem sehr effiziente Maßnahme hierzu und damit auch zur vorteilhaften Temperung des mindestens einen SiC-Volumeneinkristalls während dessen Abkühlung auf Raumtemperatur mit der erwünschten Reduzierung und Homogenisierung des Spannungshaushalts sowie des (Basalebenen-)Versetzungshaushalts im SiC-Kristallgitter.

Gemäß einer weiteren günstigen Ausgestaltung wird die zusätzliche Abdeckung unmittelbar an die Züchtungsisolation angrenzend platziert. Dadurch, dass die zusätzliche Abdeckung dann unmittelbar an der Züchtungsisolation anliegt, resultiert ein sehr niedriger Wärmeverlust und damit eine sehr hohe Wirksamkeit.

Gemäß einer weiteren günstigen Ausgestaltung wird die zusätzliche Abdeckung beabstandet von der Züchtungsisolation platziert. Insbesondere wird ein axialer Abstand zwischen der zusätzlichen Abdeckung und der Züchtungsisolation von vorzugsweise zwischen 1 mm und 10 mm vorgesehen. Dies lässt sich technisch sehr einfach realisieren.

Gemäß einer weiteren günstigen Ausgestaltung wird für die zusätzliche Abdeckung ein Aufbau vorgesehen, bei dem die zusätzliche Abdeckung eine zentrale axial durch die zusätzliche Abdeckung vollständig hindurchgehende Abdeckungsaussparung hat, und die zentrale Abdeckungsaussparung eine Querschnittsfläche hat, deren Quotient zu einer Querschnittsfläche einer stirnseitig in der Züchtungsisolation vorhandenen zentralen Isolationsaussparung insbesondere zwischen 0,1 und 0,3 liegt. Dabei ist die Querschnittsfläche der zentralen Abdeckungsaussparung der Dividend und die Querschnittsfläche der Isolationsaussparung der Divisor dieses Quotienten. Anders ausgedrückt beträgt die Querschnittsfläche der zentralen Abdeckungsaussparung insbesondere 10% bis 30% der Querschnittsfläche der Isolationsaussparung. Dadurch ergibt sich ein weiterer Justageparameter zur besonders einfachen und exakten Einstellung der gewünschten niedrigen Werte für die axialen und/oder radialen Abkühlungs-Temperaturgradienten. Die Isolationsaussparung ist insbesondere ebenfalls stirnseitig zentral angeordnet und geht insbesondere ebenfalls in axialer Richtung vollständig durch die Züchtungsisolation hindurch. Die zusätzliche Abdeckung wird vorzugsweise so platziert, dass die zentrale Abdeckungsaussparung und die Isolationsaussparung konzentrisch zueinander und insbesondere auch zur Kristallmittenlängsachse angeordnet sind und vorzugsweise miteinander fluchten.

Gemäß einer weiteren günstigen Ausgestaltung wird für die zusätzliche Abdeckung ein Aufbau vorgesehen, bei dem die zusätzliche Abdeckung mindestens zwei axial durch die zusätzliche Abdeckung vollständig hindurchgehende Abdeckungsaussparungen hat, und jede Abdeckungsaussparung eine zugehörige Querschnittsfläche hat, wobei ein Quotient der Summe der Querschnittsflächen aller Abdeckungsaussparungen und der Querschnittsfläche der stirnseitig in der Züchtungsisolation vorhandenen Isolationsaussparung insbesondere zwischen 0,1 und 0,3 liegt. Dabei ist die Summe der Querschnittsflächen aller Abdeckungsaussparungen der Dividend und die Querschnittsfläche der Isolationsaussparung der Divisor dieses Quotienten. Anders ausgedrückt beträgt die Summe der Querschnittsflächen aller Abdeckungsaussparungen insbesondere 10% bis 30% der Querschnittsfläche der Isolationsaussparung. Optional kann eine der Abdeckungsaussparungen im Zentrum der zusätzlichen Abdeckung positioniert sein, also eine zentrale Abdeckungsaussparung sein. Insbesondere sind die Abdeckungsaussparungen zumindest abgesehen von der optionalen zentralen Abdeckungsaussparung gleichmäßig verteilt angeordnet, beispielsweise in tangentialer Richtung gleichmäßig verteilt angeordnet. Vorzugsweise können die Abdeckungsaussparungen zumindest abgesehen von der optionalen zentralen Abdeckungsaussparung längs eines zur Kristallmittenlängsachse konzentrischen Kreislinie und insbesondere auch rotationssymmetrisch bezüglich der Kristallmittenlängsachse angeordnet sein.

Gemäß einer weiteren günstigen Ausgestaltung wird zwischen der Züchtungsphase und der Temperungs-Abkühlphase eine Temperungs-Haltephase durchgeführt, während der eine Temperungs-Haltetemperatur eingestellt wird, die mindestens so groß ist wie die während der Züchtungsphase eingestellte Züchtungstemperatur und insbesondere höchstens 250°C höher als die Züchtungstemperatur ist. Die Temperungs-Haltephase fördert die "in situ"-Temperung des mindestens einen SiC-Volumeneinkristalls zusätzlich. Sie trägt zusätzlich dazu bei, dass die im Kristallgitter des mindestens einen SiC-Volumeneinkristalls am Ende der Temperungs-Abkühlphase vorhandenen Spannungen und Versetzungen, insbesondere Basalebenenversetzungen, weiter reduziert und auch homogenisiert werden. Die spannungsreduzierenden Maßnahmen, wie z.B. das stirnseitige Platzieren der zusätzlichen Abdeckung benachbart zu der Züchtungsisolation, werden insbesondere schon vor oder während der Temperungs-Haltephase ergriffen.

Zur Lösung der einkristallinen SiC-Grundkörper betreffenden Aufgabe wird ein einkristalliner SiC-Grundkörper entsprechend den Merkmalen des Anspruchs 15 angegeben. Der erfindungsgemäße einkristalline SiC-Grundkörper ist aus einem sublimationsgezüchteten SiC-Volumeneinkristall hergestellt und zum Heraustrennen mehrerer einkristalliner SiC-Substrate aus dem einkristallinen SiC-Grundkörper bestimmt, wobei der einkristalline SiC-Grundkörper eine Form hat, die zumindest in einem Teilbereich die eines Kreiszylinders ist, und ein an der oberen Stirnseite aus dem einkristallinen SiC-Grundkörper heraustrennbares oberes einkristallines SiC-Substrat eine obere Basalebenenversetzungsdichte und ein an der unteren Stirnseite aus dem einkristallinen SiC-Grundkörper heraustrennbares unteres einkristallines SiC-Substrat eine untere Basalebenenversetzungsdichte aufweist, wobei sich die obere Basalebenenversetzungsdichte und die untere Basalebenenversetzungsdichte um höchstens 25 % voneinander unterscheiden.

Der erfindungsgemäße einkristalline SiC-Grundkörper ist insbesondere durch Bearbeitung eines nach dem vorstehend beschriebenen Verfahren oder nach einem seiner günstigen Ausgestaltungen sublimationsgezüchteten SiC-Volumeneinkristalls hergestellt. Diese Bearbeitung kann insbesondere durch Beschneiden und/oder Schleifen und/oder Polieren einzelner oder aller Randflächen erfolgen. Der einkristalline SiC-Grundkörper ist insbesondere exakt kreiszylindrisch. Er kann aber bevorzugt auch eine Orientierungsmarkierung haben, beispielsweise in Form einer sich in Längsrichtung des einkristallinen SiC-Grundkörpers erstreckenden ebenen Teilrandfläche oder einer sich ebenfalls in Längsrichtung erstreckenden Einkerbung, wodurch die Kreiszylinderform dann jeweils nur in dem Teilbereich außerhalb der Orientierungsmarkierung gegeben ist.

Der einkristalline SiC-Grundkörper hat insbesondere eine zentrale Grundkörpermittenlängsachse. Im Zusammenhang mit dem erfindungsgemäßen einkristallinen SiC-Grundkörper und den daraus heraustrennbaren SiC-Substraten ist mit "axial" eine Richtung parallel zur oder längs dieser zentralen Grundkörpermittenlängsachse, mit "radial" eine dazu senkrechte Richtung und mit "tangential" eine um die Grundkörpermittenlängsachse umlaufende Umfangsrichtung bezeichnet. Die Längsrichtung des einkristallinen SiC-Grundkörpers entspricht der axialen Richtung.

Das an der oberen Stirnseite aus dem einkristallinen SiC-Grundkörper heraustrennbare obere einkristalline SiC-Substrat und das an der an der unteren Stirnseite aus dem einkristallinen SiC-Grundkörper heraustrennbare untere einkristalline SiC-Substrat haben jeweils insbesondere eine Dicke von 300 $\mu$m bis 800 $\mu$m, wobei die Dicke die Ausdehnung in axialer Richtung angibt.

Der einkristalline SiC-Grundkörper hat in seinem SiC-Kristallgitter vorteilhafterweise einen sehr homogenen Basalebenenversetzungshaushalt. Die obere Basalebenenversetzungsdichte, also die Basalebenenversetzungsdichte an seiner oberen Stirnseite, unterscheidet sich nur geringfügig von der unteren Basalebenenversetzungsdichte, also der Basalebenenversetzungsdichte an seiner unteren Stirnseite. Insbesondere liegt ein Quotient zwischen der oberen Basalebenenversetzungsdichte und der unteren Basalebenenversetzungsdichte im Bereich zwischen 0,75 und 1,25 liegt. Diese vorteilhafte weitgehend homogene Verteilung der Basalebenenversetzungen innerhalb des einkristallinen SiC-Grundkörpers geht insbesondere auf das Verfahren zurück, mittels dessen der dem einkristallinen SiC-Grundkörper zugrundeliegende SiC-Volumeneinkristall hergestellt worden ist. Besonders günstig wirkt sich dabei die Temperungs-Abkühlphase des Herstellungsverfahrens auf die letztendlich im einkristallinen SiC-Grundkörper gegebene sehr homogene Verteilung der Basalebenenversetzungen aus. So verhindert die insbesondere mit den insofern günstigen sehr niedrigen Abkühlungs-Temperaturgradienten und deshalb auch insbesondere sehr langsam durchgeführte Temperungs-Abkühlphase die andernfalls auch während des Abkühlvorgangs übliche Bildung von Basalebenenversetzungen, welche sich dann auch durch eine nachgelagerte Temperung in einem gesonderten Temperungstiegel nicht mehr nennenswert ausheilen oder rückbilden lassen würden. Einkristalline SiC-Grundkörper mit einer so homogenen Verteilung der Basalebenenversetzungen lassen sich nicht durch die bislang gängigen Züchtungsverfahren herstellen. Die ist erst mit dem vorstehend beschriebenen Verfahren möglich, das die vorteilhafte den Abkühlvorgang mit einem zeitgleich und noch im Züchtungstiegel durchgeführten Temperungsvorgang kombinierende Temperungs-Abkühlphase aufweist.

Ansonsten bietet der erfindungsgemäße einkristalline SiC-Grundkörper und seine günstigen Ausgestaltungen im Wesentlichen die gleichen Vorteile, die bereits im Zusammenhang mit dem erfindungsgemäßen Herstellungsverfahren und dessen günstigen Ausgestaltungen beschrieben worden sind.

Im Folgenden werden günstige Ausgestaltungen des erfindungsgemäßen einkristallinen SiC-Grundkörper beschrieben.

Günstig ist eine Ausgestaltung, bei der sich die obere Basalebenenversetzungsdichte und die untere Basalebenenversetzungsdichte um höchstens 20 %, und insbesondere um höchstens 15 %, voneinander unterscheiden. Dadurch liegt ein noch homogenerer Basalebenenversetzungshaushalt vor.

Gemäß einer weiteren günstigen Ausgestaltung weist das obere SiC-Substrat einen ersten Bow und das untere SiC-Substrat einen zweiten Bow auf, wobei sich der erste Bow und der zweite Bow um höchstens 25 % voneinander unterscheiden. Dabei ist "Bow" ein auch im Deutschen in Fachkreisen gebräuchlicher englischer Fachbegriff für eine Verbiegung oder Durchbiegung des SiC-Substrats. "Bow" bezeichnet den im Zentrum des freien, nicht geklemmten SiC-Substrats gegebenen Abstand zwischen einer Referenzebene, insbesondere einer Dreipunktreferenzebene, und einer Oberfläche des SiC-Substrats. Anstelle der Oberfläche des SiC-Substrats kann insbesondere auch eine innerhalb des freien, nicht geklemmten SiC-Substrats und im Wesentlichen parallel zu der Oberfläche verlaufende Medianfläche verwendet werden. Bow-Werte können positiv oder negativ sein.

Gemäß einer weiteren günstigen Ausgestaltung weist das obere SiC-Substrat einen ersten Warp und das untere SiC-Substrat einen zweiten Warp auf, wobei sich der erste Warp und der zweite Warp um höchstens 25 % voneinander unterscheiden. Dabei ist "Warp" ein auch im Deutschen in Fachkreisen gebräuchlicher englischer Fachbegriff für eine Krümmung oder Wölbung des SiC-Substrats. "Warp" bezeichnet die Summe des Betrags des größten Abstands einer Oberfläche des freien, nicht geklemmten SiC-Substrats von einer Referenzebene, insbesondere von einer Dreipunktreferenzebene, (= erster Summand) und des Betrags des kleinsten Abstands der Oberfläche des freien, nicht geklemmten SiC-Substrats von der Referenzebene (= zweiter Summand). Anstelle der Oberfläche des SiC-Substrats kann insbesondere auch eine innerhalb des freien, nicht geklemmten SiC-Substrats und im Wesentlichen parallel zu der Oberfläche verlaufende Medianfläche verwendet werden. Warp-Werte sind immer positiv.

Gemäß einer weiteren günstigen Ausgestaltung hat der einkristalline SiC-Grundkörper einen Grundkörperdurchmesser von mindestens 150 mm, insbesondere von mindestens 200 mm. Bevorzugt liegt der Grundkörperdurchmesser bei 150 mm oder bei etwa 200 mm. Eine derzeit fertigungsbedingte Obergrenze des Grundkörperdurchmessers liegt insbesondere bei etwa 300 mm, wobei grundsätzlich aber auch noch größere Grundkörperdurchmesser denkbar sind. Der Grundkörperdurchmesser entspricht dabei dem Substratdurchmesser von aus dem einkristallinen SiC-Grundkörper herausgetrennten einkristallinen SiC-Substraten. Je größer der Grundkörperdurchmesser und damit auch der Substratdurchmesser ist, umso effizienter können aus dem einkristallinen SiC-Grundkörper herausgetrennte einkristalline SiC-Substrate beispielsweise zur Herstellung von Halbleiter- und/oder Hochfrequenzbauelementen weiterverwendet werden. Dadurch sinken die Bauelemente-Herstellungskosten. Ein SiC-Substrat mit einem so großen Durchmesser kann mit Vorteil außerdem auch zur Herstellung von relativ großen Halbleiter- und/oder Hochfrequenzbauelementen, die z.B. eine Grundfläche von etwa 1 cm$^2$ haben, verwendet werden.

Gemäß einer weiteren günstigen Ausgestaltung hat der einkristalline SiC-Grundkörper eine zentrale Grundkörpermittenlängsachse, die gegenüber der Flächennormalen der Basalebene der Kristallstruktur des einkristallinen SiC-Grundkörpers um einen Verkippungswinkel, der insbesondere größer als 0° ist und vorzugsweise höchstens bei etwa 8° liegt, verkippt ist. Bevorzugt liegt der Verkippungswinkel bei etwa 4°. Insbesondere hat der einkristalline SiC-Grundkörper eine gegenüber der SiC-Kristallstruktur verkippte Orientierung (= off-Orientierung). Bevorzugt ist die zentrale Grundkörpermittenlängsachse gegenüber der Richtung der Flächennormalen der Basalebene [0001] in Richtung der [11-20]-Kristallrichtung verkippt. Die Basalebene ist insbesondere die (0001)-Ebene der SiC-Kristallstruktur. Bei einer off-Orientierung des einkristallinen SiC-Grundkörpers gegenüber der SiC-Kristallstruktur fallen die zentrale Grundkörpermittenlängsachse des einkristallinen SiC-Grundkörper und die zentrale Kristallmittenlängsachse des SiC-Volumeneinkristalls, aus dem der einkristalline SiC-Grundkörper hergestellt ist, insbesondere auseinander. Die zentrale Grundkörpermittenlängsachse und die zentrale Kristallmittenlängsachse, die in die Wachstumsrichtung des sublimationsgezüchteten SiC-Volumeneinkristalls orientiert ist, sind dann insbesondere ebenfalls um den Verkippungswinkel gegeneinander verkippt.

Gemäß einer weiteren günstigen Ausgestaltung hat der einkristalline SiC-Grundkörper eine längs seiner zentralen Grundkörpermittenlängsachse gemessene Grundkörperlänge von 20 mm bis 60 mm, insbesondere von 25 mm bis 50 mm.

Gemäß einer weiteren günstigen Ausgestaltung hat einkristalline SiC-Grundkörper eine SiC-Kristallstruktur mit nur einem einzigen SiC-Polytyp, insbesondere mit einem der SiC-Polytypen 4H, 6H, 15R und 3C. Bevorzugt liegt eine hohe Modifikationsstabilität vor, die sich insbesondere durch die weitest gehende Abwesenheit von Polytypwechseln auszeichnet. Wenn der einkristalline SiC-Grundkörper nur einen einzigen SiC-Polytyp aufweist, hat er vorteilhafterweise auch nur eine sehr geringe Defektdichte. Aus ihm können dann qualitativ sehr hochwertiges SiC-Substrate herausgetrennt werden. Besonders bevorzugt ist der Polytyp 4H.

Weitere Merkmale, Vorteile und Einzelheiten der Erfindung ergeben sich aus der nachfolgenden Beschreibung von Ausführungsbeispielen anhand der Zeichnung. Es zeigt:

Fig. 1 ein Ausführungsbeispiel einer Züchtungsanordnung zur Sublimationszüchtung eines SiC-Volumeneinkristalls,

Fig. 2 bis 4 Ausführungsbeispiele von Züchtungsanordnungen zur Sublimationszüchtung eines SiC-Volumeneinkristalls mit einer während einer Temperungs-Abkühlphase zuschaltbaren spannungsreduzierenden Maßnahme,

Fig. 5 ein Ausführungsbeispiel einer Züchtungsanordnung zur Sublimationszüchtung von zwei SiC-Volumeneinkristallen mit während einer Temperungs-Abkühlphase zuschaltbaren spannungsreduzierenden Maßnahmen, und

Fig. 6 ein Ausführungsbeispiel eines aus einem SiC-Volumenkristall, der mittels einer Züchtungsanordnungen gemäß Fig. 2 bis 5 gezüchtet worden ist, hergestellten einkristallinen SiC-Grundkörpers.

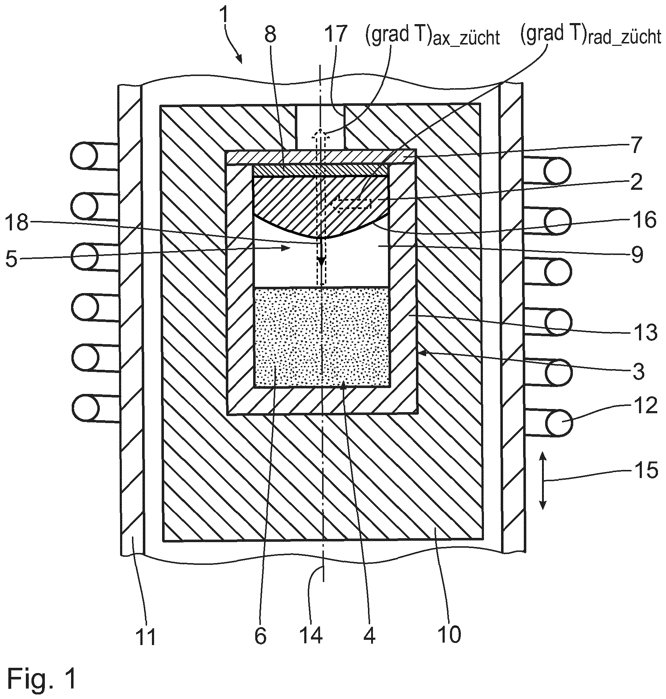

Einander entsprechende Teile sind in den Fig. 1 bis 6 mit denselben Bezugszeichen versehen. Auch Einzelheiten der im Folgenden näher erläuterten Ausführungsbeispiele können für sich genommen eine Erfindung darstellen oder Teil eines Erfindungsgegenstands sein.

In Fig. 1 ist ein Ausführungsbeispiel einer Züchtungsanordnung 1 zur Herstellung eines SiC-Volumeneinkristalls 2 mittels Sublimationszüchtung dargestellt. Die Züchtungsanordnung 1 enthält einen Züchtungstiegel 3, der einen SiC-Vorratsbereich 4 sowie einen Kristallwachstumsbereich 5 umfasst. In dem SiC-Vorratsbereich 4 befindet sich beispielsweise pulverförmiges SiC-Quellmaterial 6, das als vorgefertigtes Ausgangsmaterial vor Beginn des Züchtungsprozesses in den SiC-Vorratsbereich 4 des Züchtungstiegels 3 eingefüllt wird.

Im Bereich einer dem SiC-Vorratsbereich 4 gegenüberliegenden Tiegelstirnwand 7 des Züchtungstiegels 3 ist ein sich axial bis in den Kristallwachstumsbereich 5 erstreckender SiC-Keimkristall 8 angebracht. Der SiC-Keimkristall 8 ist insbesondere einkristallin. Die Tiegelstirnwand 7 ist beim gezeigten Ausführungsbeispiel als Tiegeldeckel des Züchtungstiegels 3 ausgebildet. Dies ist aber nicht zwingend. Auf dem SiC-Keimkristall 8 wächst der zu züchtende SiC-Volumeneinkristall 2 mittels Abscheidung aus einer sich im Kristallwachstumsbereich 5 ausbildenden SiC-Wachstumsgasphase 9 auf. Der aufwachsende SiC-Volumeneinkristall 2 und der SiC-Keimkristall 8 haben in etwa den gleichen Durchmesser. Wenn überhaupt, ergibt sich eine Abweichung von höchstens 10%, um die ein Keimdurchmesser des SiC-Keimkristalls 8 kleiner ist als ein Einkristalldurchmesser des SiC-Volumeneinkristalls 2. Allerdings kann zwischen der Innenseite einer Tiegelseitenwand 13 einerseits und dem aufwachsenden SiC-Volumeneinkristall 2 sowie dem SiC-Keimkristall 8 andererseits ein in Fig. 1 nicht gezeigter Spalt vorhanden sein.

Der Züchtungstiegel 3 inklusive des Tiegeldeckels 7 besteht bei dem Ausführungsbeispiel gemäß Fig. 1 aus einem elektrisch und thermisch leitfähigen Graphit-Tiegelmaterial mit einer Dichte von z.B. mindestens 1,75 g/cm$^3$. Um ihn herum ist eine thermische Züchtungsisolation 10 angeordnet. Letztere besteht z.B. aus einem Isolationsmaterial, das ein schaumartiges Kohlenstoff-Kompositmaterial mit einer Kohlenstoffmatrix und darin eingebetteten Kohlenstofffasern ist, und dessen Porosität insbesondere deutlich höher ist als die des Graphit-Tiegelmaterials.

Der thermisch isolierte Züchtungstiegel 3 ist innerhalb eines rohrförmigen Behälters 11 platziert, der beim Ausführungsbeispiel als Quarzglasrohr ausgeführt ist und einen Autoklaven oder Reaktor bildet. Zur Beheizung des Züchtungstiegels 3 ist um den Behälter 11 ist eine induktive Heizeinrichtung in Form einer Heizspule 12 angeordnet. Der Züchtungstiegel 3 wird mittels der Heizspule 12 auf die für die Züchtung erforderlichen Temperaturen erhitzt. Bei dem gezeigten Ausführungsbeispiel liegen diese Züchtungstemperaturen bei mindestens 2250°C. Die Heizspule 12 koppelt einen elektrischen Strom induktiv in die elektrisch leitfähige Tiegelseitenwand 13 des Züchtungstiegels 3 ein. Dieser elektrische Strom fließt im Wesentlichen als Kreisstrom in Umfangsrichtung innerhalb der kreis- und hohlzylindrischen Tiegelseitenwand 13 und heizt dabei den Züchtungstiegel 3 auf. Bei Bedarf kann die relative Position zwischen der Heizspule 12 und dem Züchtungstiegel 3 axial, d.h. in die Richtung einer Kristallmittenlängsachse 14 des aufwachsenden SiC-Volumeneinkristalls 2, verändert werden, insbesondere um die Temperatur bzw. den Temperaturverlauf innerhalb des Züchtungstiegels 3 einzustellen und ggf. auch zu verändern. Die während des Züchtungsprozesses axial veränderbare Position der Heizspule 12 ist in Fig. 1 durch den Doppelpfeil 15 angedeutet. Insbesondere wird die Heizspule 12 an den Wachstumsfortschritt des aufwachsenden SiC-Volumeneinkristalls 2 angepasst verschoben. Die Verschiebung erfolgt vorzugsweise nach unten, also in Richtung des SiC-Quellmaterials 6, und bevorzugt um die gleiche Länge, um die der SiC-Volumeneinkristall 2 aufwächst, z.B. insgesamt um etwa 20 mm. Hierzu umfasst die Züchtungsanordnung 1 nicht näher gezeigte entsprechend ausgestaltete Kontroll-, Steuer- und Verstellmittel.

Die SiC-Wachstumsgasphase 9 im Kristallwachstumsbereich 5 wird durch das SiC-Quellmaterial 6 gespeist. Die SiC-Wachstumsgasphase 9 enthält zumindest Gasbestandteile in Form von Si, $Si_2C$ und $SiC_2$ (= SiC-Gasspezies). Der Materialtransport vom SiC-Quellmaterial 6 zu einer Wachstumsgrenzfläche 16 am aufwachsenden SiC-Volumeneinkristall 2 erfolgt einerseits längs eines axialen Züchtungs-Temperaturgradienten (grad T)$_{ax\_zücht}$. Bei dem für die SiC-Kristallzüchtung verwendeten Sublimationsverfahren (= PVT-Verfahren) werden die Wachstumsbedingungen inklusive des Materialtransports über die im Züchtungstiegel 3 herrschenden Temperaturen eingestellt und geregelt. An der Wachstumsgrenzfläche 16 herrscht eine relativ hohe Züchtungstemperatur von mindestens 2250°C, insbesondere sogar von mindestens 2350°C oder 2400°C°. Außerdem wird an der Wachstumsgrenzfläche 16 insbesondere ein in Richtung der Kristallmittenlängsachse 14 gemessener axialer Züchtungs-Temperaturgradient (grad T)$_{ax\_zücht}$ von mindestens 5 K/cm, vorzugsweise von mindestens 15 K/cm, eingestellt. Die Temperatur innerhalb des Züchtungstiegels 3 nimmt in axialer Richtung zu dem aufwachsenden SiC-Volumeneinkristall 2 hin ab. Die höchste Temperatur liegt mit etwa 2450°C bis 2550°C im Bereich des SiC-Vorratsbereichs 4. Dieser Temperaturverlauf mit einer Temperaturdifferenz von insbesondere 100°C bis 150°C zwischen dem SiC-Vorratsbereich 4 und der der Wachstumsgrenzfläche 16 lässt sich über verschiedene Maßnahmen erreichen. So kann über eine nicht näher gezeigte Aufteilung der Heizspule 12 in zwei oder mehrere axiale Teilabschnitte eine axial variierende Beheizung vorgesehen werden. Weiterhin kann im unteren Abschnitt des Züchtungstiegels 3, z.B. durch eine entsprechende axiale Positionierung der Heizspule 12, eine stärkere Heizwirkung eingestellt werden als im oberen Abschnitt des Züchtungstiegels 3. Außerdem kann die Wärmedämmung an den beiden axialen Tiegelstirnwänden unterschiedlich ausgebildet sein. Wie in Fig. 1 schematisch angedeutet kann hierzu die thermische Züchtungsisolation 10 an der unteren Tiegelstirnwand eine andere axiale Dicke haben als an der oberen Tiegelstirnwand. Weiterhin ist es möglich, dass die thermische Züchtungsisolation 10 stirnseitig benachbart zu der oberen Tiegelstirnwand 7, eine um die Kristallmittenlängsachse 14 angeordnete zentrale Kühlöffnung in Form einer zentralen Isolationsaussparung 17 aufweist, durch die Wärme abgeführt wird.

Auch in radialer Richtung ist ein Temperaturverlauf vorgesehen. Ein radialer Züchtungs-Temperaturgradient (grad T)$_{rad\_zücht}$ wird so eingestellt, dass am radialen Rand des aufwachsenden SiC-Volumeneinkristalls 2 eine höhere Temperatur herrscht als im Zentrum des aufwachsenden SiC-Volumeneinkristalls 2, insbesondere um Einwüchse ausgehend vom radialen Rand zu vermeiden. Der SiC-Volumeneinkristall 2 wächst somit im Zentrum etwas schneller als an seinem radialen Rand. Dadurch ergibt sich die in Fig. 1 angedeutete nach unten vorgewölbte kappenartige Form der Wachstumsgrenzfläche 16.

Außerdem herrscht in dem Züchtungstiegel 3 während der eigentlichen Kristallzüchtung ein Züchtungsdruck von insbesondere 0,1 hPa (= mbar) bis 10 hPa (= mbar).

Der SiC-Volumeneinkristall 2 wächst in einer Wachstumsrichtung 18, die im in Fig. 1 gezeigten Ausführungsbeispiel von oben nach unten, also vom Tiegeldeckel 7 hin zu dem SiC-Vorratsbereich 4, orientiert ist. Die Wachstumsrichtung 18 verläuft parallel zu der zentralen Kristallmittenlängsachse 14. Da der aufwachsende SiC-Volumeneinkristall 2 bei dem gezeigten Ausführungsbeispiel konzentrisch innerhalb der Züchtungsanordnung 1 angeordnet ist, ist die zentrale Kristallmittenlängsachse 14 zugleich auch die Mittenlängsachse der Züchtungsanordnung 1.

Der aufwachsende SiC-Volumeneinkristall 2 hat eine SiC-Kristallstruktur vom 4H-Polytyp. Grundsätzlich ist aber auch ein anderer Polytyp (= eine andere Kristallmodifikation), wie z.B. 6H-SiC, 3C-SiC oder 15R-SiC, möglich. Vorteilhafterweise hat der SiC-Volumeneinkristall 2 nur einen einzigen SiC-Polytyp, welcher bei dem Ausführungsbeispiel besagtes 4H-SiC ist. Der SiC-Volumeneinkristall 2 wächst mit einer hohen Modifikationsstabilität auf und hat insofern im Wesentlichen nur einen einzigen Polytyp. Letzteres ist günstig im Hinblick auf eine sehr defektarme hohe Kristallqualität.

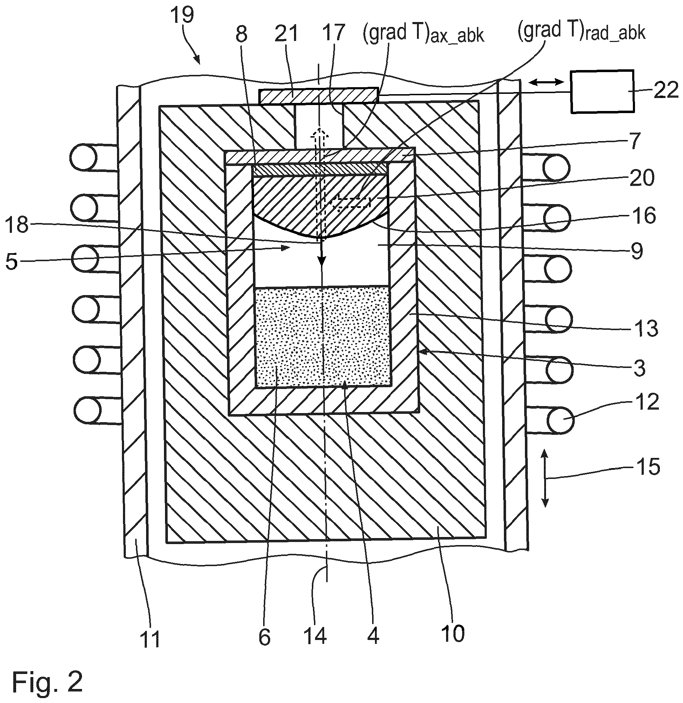

In Fig. 2 ist ein Ausführungsbeispiel einer weiteren Züchtungsanordnung 19 zur Sublimationszüchtung eines SiC-Volumeneinkristalls 20 gezeigt. Von der Züchtungsanordnung 1 gemäß Fig. 1 unterscheidet sich die Züchtungsanordnung 19 gemäß Fig. 2 im Wesentlichen durch eine zusätzliche Abdeckung 21, die stirnseitig, nämlich auf die der Tiegelstirnwand 7 gegenüberliegenden Seite der Züchtungsisolation 10, unmittelbar auf der Züchtungsisolation 10 platzierbar ist. Die zusätzliche Abdeckung 21 besteht aus dem gleichen Material wie die Züchtungsisolation 10 und ist insbesondere ebenfalls ein thermisch isolierendes Element. Sie ist als eine zylindrische Platte ausgebildet und hat eine axiale Dicke von insbesondere zwischen 10 mm und 100 mm. Die zusätzliche Abdeckung 21 lässt sich mittels eines Steuerungs- und Verstellmechanismus 22 in ihre gewünschte Wirkposition stirnseitig auf der Züchtungsisolation 10 bringen. In dieser in Fig. 2 gezeigten Wirkposition bedeckt sie die zentrale Isolationsaussparung 17 und ist konzentrisch zur Kristallmittenlängsachse 14 angeordnet.

Während der eigentlichen Züchtungsphase befindet sich die zusätzliche Abdeckung 21 nicht in ihrer Wirkposition. Die eigentliche Züchtungsphase findet bei der Züchtungsanordnung 19 mit einem im Wesentlichen gleichen Aufbau wie bei der Züchtungsanordnung 1 gemäß Fig. 1 statt, also ohne die zusätzliche Abdeckung 21. Sie wird erst nach Abschluss der eigentlichen Züchtungsphase in ihre in Fig. 2 gezeigte Wirkposition gebracht, wo sie dann auch während der sich anschließenden Temperungs-Abkühlphase bleibt. Während der Temperungs-Abkühlphase stellt die zusätzliche Abdeckung 21 ein Mittel zur Reduktion sowie zur Homogenisierung von Spannungen und/oder Basalebenenversetzungen innerhalb des aufgewachsenen SiC-Volumeneinkristalls 19 dar. Sie trägt dazu bei, dass während der Temperungs-Abkühlphase für den axialen Abkühlungs-Temperaturgradienten (grad T)$_{ax\_abk}$ ein Wert von höchstens 40 %, insbe-

EP 4 779 062 A1

sondere von höchstens 30 % des am Ende der Züchtungsphase herrschenden axialen Züchtungs-Temperaturgradienten (grad T)$_{ax\_zücht}$ und für den radialen Abkühlungs-Temperaturgradienten (grad T)$_{rad\_abk}$ ein Wert von höchstens 40 %, insbesondere von höchstens 30 % des am Ende der Züchtungsphase herrschenden radialen Züchtungs-Temperaturgradienten (grad T)$_{ax\_zücht}$ eingestellt, also dass die Bedingungen der vorstehenden Gleichungen (1a) oder (2a) und (4a) bzw. (1b) oder (2b) und (4b) erfüllt sind. Der axiale Abkühlungs-Temperaturgradient und der radiale Abkühlungs-Temperaturgradient haben somit nur sehr niedrige Werte, so dass die Temperungs-Abkühlphase länger dauert als bei einer Abkühlung ohne Verwendung der zusätzlichen Abdeckung 21. Dadurch ergibt sich ein positiver Effekt im Hinblick auf eine Reduzierung und Homogenisierung des Spannungshaushalts und auch des Basalebenenversetzungshaushalts im zuvor aufgewachsenen SiC-Volumeneinkristall 19. Am Ende der Temperungs-Abkühlphase, die Bestandteil des Gesamtzüchtungsprozesses für den SiC-Volumeneinkristall 19 ist, liegt der SiC-Volumeneinkristall 19 in sehr hoher Qualität mit wenigen homogen verteilten Spannungen und Basalebenenversetzungen vor.

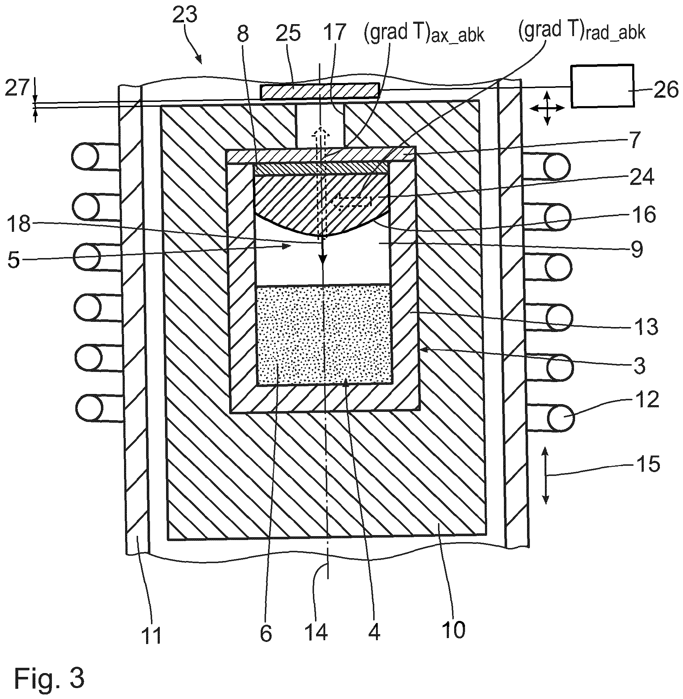

In Fig. 3 ist ein Ausführungsbeispiel einer weiteren Züchtungsanordnung 23 zur Sublimationszüchtung eines SiC-Volumeneinkristalls 24 gezeigt.

Wie bei der Züchtungsanordnung 19 gemäß Fig. 2 hat auch die Züchtungsanordnung 23 eine zusätzliche Abdeckung 25, die wiederum ein Mittel zur Reduktion sowie zur Homogenisierung von Spannungen und/oder Basalebenenversetzungen innerhalb des aufgewachsenen SiC-Volumeneinkristalls 24 ist. Der wesentliche Unterschied zur Züchtungsanordnung 19 gemäß Fig. 2 besteht darin, dass die zusätzliche Abdeckung 25 nicht unmittelbar angrenzend auf die Züchtungsisolation 10, sondern mittels eines entsprechend ausgebildeten Steuerungs- und Verstellmechanismus 26 mit einem axialen Abstand 27 zu der Züchtungsisolation 10 platzierbar ist. Der axiale Abstand 27 hat insbesondere einen Wert zwischen 1 mm und 10 mm. Ansonsten sind Aufbau und Wirkungsweise der zusätzlichen Abdeckung 25 gleich wie bei der zusätzlichen Abdeckung 21.

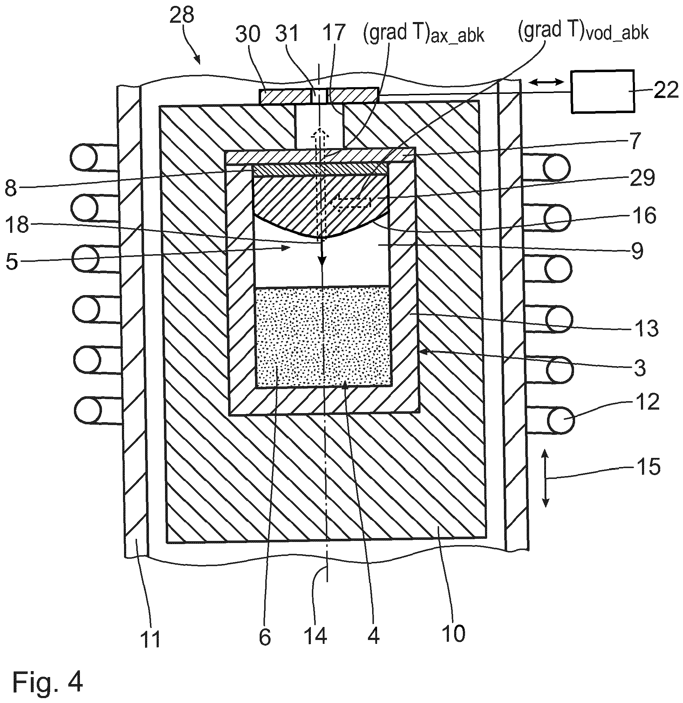

In Fig. 4 ist ein Ausführungsbeispiel einer weiteren Züchtungsanordnung 28 zur Sublimationszüchtung eines SiC-Volumeneinkristalls 29 gezeigt. Wie bei den Züchtungsanordnungen 19 und 23 gemäß Fig. 1 bzw. 2 hat auch die Züchtungsanordnung 28 eine zusätzliche Abdeckung 30, die wiederum ein Mittel zur Reduktion sowie zur Homogenisierung von Spannungen und/oder Basalebenenversetzungen innerhalb des aufgewachsenen SiC-Volumeneinkristalls 29 ist. Der wesentliche Unterschied zur Züchtungsanordnung 19 gemäß Fig. 2 besteht darin, dass die zusätzliche Abdeckung 30 eine zentrale axial durch die zusätzliche Abdeckung 30 vollständig hindurchgehende Abdeckungsaussparung 31 hat. Deren Querschnittsfläche beträgt insbesondere 10% bis 30% der Querschnittsfläche der Isolationsaussparung 17. Die zusätzliche Abdeckung 30 ist mittels des Steuerungs- und Verstellmechanismus 22 so platzierbar, dass die zentrale Abdeckungsaussparung 31 und die Isolationsaussparung 17 konzentrisch zueinander und insbesondere auch zur Kristallmittenlängsachse 14 angeordnet sind und miteinander fluchten, und dass die zusätzliche Abdeckung 30 unmittelbar auf der Züchtungsisolation 10 aufliegt. Bei einem alternativen nicht gezeigten Ausführungsbeispiel kann die zusätzliche Abdeckung 30 auch axial beabstandet zu der Züchtungsisolation 10 platziert werden. Ansonsten sind Aufbau und Wirkungsweise der zusätzlichen Abdeckung 30 gleich wie bei den zusätzlichen Abdeckungen 21 und 25.

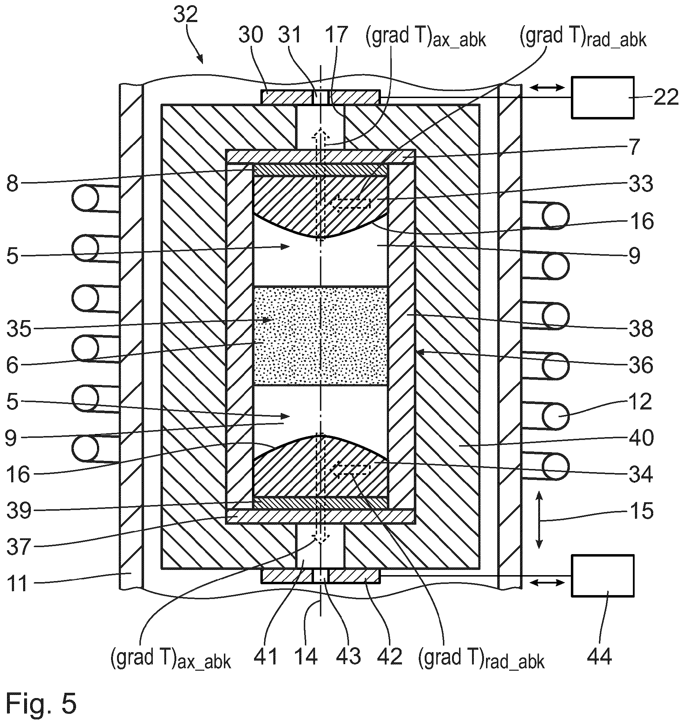

In Fig. 5 ist ein Ausführungsbeispiel einer weiteren Züchtungsanordnung 32 zur Sublimationszüchtung von zwei SiC-Volumeneinkristallen 33 und 34 gezeigt. Die Züchtungsanordnung 32 ergibt sich im Wesentlichen durch eine Verdoppelung der Züchtungsanordnung 28, nämlich durch eine axiale Spiegelung der Züchtungsanordnung 28 nach unten. Bei der Züchtungsanordnung 32 sind die meisten Komponenten gleich wie bei der Züchtungsanordnung 28, weshalb sie auch die gleichen Bezugszeichen haben. Dies gilt auch für die nach unten gespiegelte zweite Teilanordnung. Im Folgenden werden nur die aufgrund der Verdoppelung verglichen mit der Züchtungsanordnung 28 anders ausgestalteten Komponenten näher beschrieben.

Ein beide aufzuwachsenden SiC-Volumeneinkristalle 33 und 34 speisender SiC-Vorratsbereich 35 mit SiC-Quellmaterial 6 ist axial mittig in einem Züchtungstiegel 36 angeordnet. Der Züchtungstiegel 36 hat neben der oberen Tiegelstirnwand 7 eine vergleichbare untere Tiegelstirnwand 37 sowie eine hohlzylindrische Tiegelseitenwand 38. Wie die obere Tiegelstirnwand 7 den SiC-Keimkristall 8 trägt, auf der der erste SiC-Volumeneinkristall 34 aufwächst, trägt die untere Tiegelstirnwand 37 einen SiC-Keimkristall 39, auf den der zweite SiC-Volumeneinkristall 34 aufwächst. Die Teilanordnungen zur Züchtung beider SiC-Volumeneinkristalle 33 und 34 sind zueinander fluchtend übereinander angeordnet, so dass für beide SiC-Volumeneinkristalle 33 und 34 die gleiche Kristallmittenlängsachse 14 gilt, die zugleich auch die Mittenlängsachse der Züchtungsanordnung 32 ist.

Eine den Züchtungstiegel 36 umgebende thermische Züchtungsisolation 40 hat neben der oberen Isolationsaussparung 17 angrenzend zur oberen Tiegelstirnwand 7 eine analoge untere Isolationsaussparung 41 angrenzend zur unteren Tiegelstirnwand 37. Außerdem ist eine im Bereich der unteren Isolationsaussparung 41 platzierbare zusätzliche Abdeckung 42 mit einer zentralen Abdeckungsaussparung 43 vorgesehen. Die zusätzliche Abdeckung 42 ist mittels eines Steuerungs- und Verstellmechanismus 44 so platzierbar, dass die zentrale Abdeckungsaussparung 43 und die untere Isolationsaussparung 41 konzentrisch zueinander und insbesondere auch zur Kristallmittenlängsachse 14 angeordnet sind und miteinander fluchten, und dass die zusätzliche Abdeckung 42 unmittelbar an der Züchtungsisolation 40 anliegt. Die zusätzliche Abdeckung 42 ist wiederum ein Mittel zur Reduktion sowie zur Homogenisierung von Spannungen und/oder Basalebenenversetzungen innerhalb des unteren aufgewachsenen SiC-Volumeneinkristalls 34. Die für die untere axiale Stirnseite vorgesehene zusätzliche Abdeckung 42 ist baugleich zu der für die obere axiale Stirnseite vorgesehenen zusätzlichen Abdeckung 30. Ansonsten sind Aufbau und Wirkungsweise der zusätzlichen Abdeckungen 30 und 42 gleich wie bei den zusätzlichen Abdeckungen 21 und 25.

Alle zusätzlichen Abdeckungen 21, 25, 30 und 42 sind für die Temperungs-Abkühlphase zuschaltbare Maßnahmen, die zur Herbeiführung der vorstehend erläuterten Temperungswirkung während des Abkühlvorgangs und damit zur Qualitätsverbesserung des jeweiligen gezüchteten SiC-Volumeneinkristalls 20, 24, 29, 33 oder 34 dienen.

Mittels der Züchtungsanordnungen 19, 23, 28 und 32 lassen sich insbesondere die im allgemeinen Beschreibungsteil angesprochenen Züchtungsverfahren durchführen.

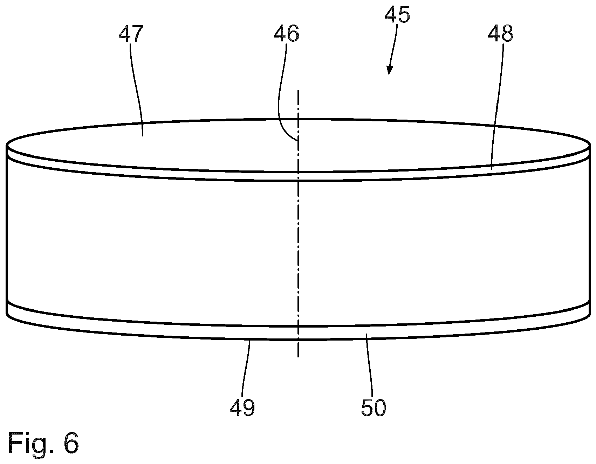

In Fig. 6 ist ein Ausführungsbeispiel eines aus einem der SiC-Volumenkristalle 20, 24, 29, 33 und 34 hergestellten einkristallinen SiC-Grundkörpers 45 gezeigt. Die Herstellung des SiC-Grundkörpers 45 erfolgt dabei durch Beschneiden und/oder Schleifen und/oder Polieren einzelner oder aller Randflächen. Der resultierende einkristalline SiC-Grundkörper 45 gemäß Fig. 6 ist exakt kreiszylindrisch und hat eine zentrale Grundkörpermittenlängsachse 46. Es gibt auch ein alternatives, in den Figuren nicht dargestelltes Ausführungsbeispiel, bei dem der SiC-Grundkörper nicht exakt kreiszylindrisch ist, sondern eine zusätzliche Orientierungsmarkierung, beispielsweise in Form einer Abflachung (englischer Fachbegriff "flat") oder einer Einkerbung (englischer Fachbegriff "notch"), aufweist. Aus dem einkristallinen SiC-Grundkörper 45 lassen sich durch axial sukzessives Abschneiden dünner Scheiben einkristalline SiC-Substrate für die Fertigung von Halbleiter- und/oder Hochfrequenzbauelementen gewinnen.

In der Abbildung gemäß Fig. 6 sind auch ein an der oberen Stirnseite 47 aus dem einkristallinen SiC-Grundkörper 45 heraustrennbares oberes einkristallines SiC-Substrat 48 sowie ein an der unteren Stirnseite 49 aus dem einkristallinen SiC-Grundkörper 45 heraustrennbares unteres einkristallines SiC-Substrat 50 mit dargestellt. Der einkristalline SiC-Grundkörper 45 hat eine vorteilhaft homogene Verteilung der Basalebenenversetzungen in axialer Richtung. Das obere einkristalline SiC-Substrat 48 hat eine obere Basalebenenversetzungsdichte und das untere einkristalline SiC-Substrat 48 eine untere Basalebenenversetzungsdichte, wobei sich die obere Basalebenenversetzungsdichte und die untere Basalebenenversetzungsdichte um höchstens 25 % voneinander unterscheiden. Diese sehr niedrige Abweichung zwischen Basalebenenversetzungsdichten an der oberen und der unteren axialen Stirnseite 47 und 49 ist auf die vorteilhafte Homogenisierung der Basalebenenversetzungen während der Temperungs-Abkühlphase im Züchtungsprozess des zugrundeliegenden SiC-Volumeneinkristalls 20, 24, 29, 33 oder 34 zurückzuführen.

Außerdem hat der einkristalline SiC-Grundkörper 45 auch eine vorteilhaft homogene Spannungsverteilung in axialer Richtung. Spannungen im SiC-Kristallgitter können zu Verbiegungen (Bow) und/oder zu Krümmungen (Warp) von aus dem einkristallinen SiC-Grundkörper 45 herausgetrennten SiC-Substraten führen.

Das obere SiC-Substrat 48 hat einen ersten Bow und das untere SiC-Substrat 50 einen zweiten Bow, wobei sich der erste Bow und der zweite Bow aufgrund der günstigen Homogenisierung von Spannungen während der Temperungs-Abkühlphase im Züchtungsprozess des zugrundeliegenden SiC-Volumeneinkristalls 20, 24, 29, 33 oder 34 nur um höchstens 25 % voneinander unterscheiden. Gleiches gilt für die Krümmungen. Das obere SiC-Substrat 48 hat einen ersten Warp und das untere SiC-Substrat 50 einen zweiten Warp, wobei sich der erste Warp und der zweite Warp aufgrund der günstigen Homogenisierung von Spannungen während der Temperungs-Abkühlphase im Züchtungsprozess des zugrundeliegenden SiC-Volumeneinkristalls 20, 24, 29, 33 oder 34 nur um höchstens 25 % voneinander unterscheiden.

Insgesamt ist der einkristalline SiC-Grundkörper 45 aufgrund des vorteilhaften Züchtungsverfahrens sehr hochwertig und eignet sich sehr gut für die Herstellung von ebenfalls hochwertigen einkristallinen SiC-Substraten für die von Halbleiter- und/oder Hochfrequenzbauelementen.

### Patentansprüche

1. Verfahren zur Herstellung mindestens eines SiC-Volumeneinkristalls (20; 24; 29; 33, 34) mittels einer Sublimationszüchtung, wobei

   a) vor dem Züchtungsbeginn in mindestens einem Kristallwachstumsbereich (5) eines Züchtungstiegels (3; 36) mindestens ein SiC-Keimkristall (8; 39) angeordnet wird, und in einen SiC-Vorratsbereich (4; 35) des Züchtungstiegels (3; 36) SiC-Quellmaterial (6) eingebracht wird,
   b) während einer Züchtungsphase mittels Sublimation des SiC-Quellmaterials (6) und mittels Transport der sublimierten gasförmigen Komponenten in den mindestens einen Kristallwachstumsbereich (5) dort eine SiC-Wachstumsgasphase (9) erzeugt wird, und der mindestens eine eine zentrale Kristallmittenlängsachse (14) aufweisende SiC-Volumeneinkristall (20; 24; 29; 33, 34) mittels Abscheidung aus der SiC-Wachstumsgasphase (9) auf dem mindestens einen SiC-Keimkristall (8; 39) aufwächst,

   **dadurch gekennzeichnet, dass**
   c) während einer nach Abschluss der Züchtungsphase in dem Züchtungstiegel durchgeführten Temperungs-Abkühlphase der zuvor gezüchtete mindestens eine SiC-Volumeneinkristall (20; 24; 29; 33, 34) abgekühlt wird, wobei innerhalb des mindestens einen SiC-Volumeneinkristalls (20; 24; 29; 33, 34) ein in Richtung der zentralen Kristallmittenlängsachse (14) gemessener axialer Abkühlungs-Temperaturgradienten vorgesehen wird, und ein axialer Quotient zwischen dem axialen Abkühlungs-Temperaturgradienten und einem am Ende der vorangegangenen Züchtungsphase innerhalb des mindestens einen aufgewachsenen SiC-Volumeneinkristalls (20; 24; 29; 33, 34) herrschenden und ebenfalls in Richtung der zentralen Kristallmittenlängsachse (14) gemessenen axialen Züchtungs-Temperaturgradienten höchstens einen axialen Vergleichswert von 0,4 hat.

2. Verfahren nach Anspruch 1, **dadurch gekennzeichnet, dass** der axiale Abkühlungs-Temperaturgradient so vorgesehen wird, dass der axiale Quotient zwischen dem axialen Abkühlungs-Temperaturgradienten und dem am Ende der vorangegangenen Züchtungsphase innerhalb des mindestens einen aufgewachsenen SiC-Volumeneinkristalls (20; 24; 29; 33, 34) herrschenden axialen Züchtungs-Temperaturgradienten höchstens einen axialen Vergleichswert von 0,3 hat.

3. Verfahren nach Anspruch 1 oder 2, **dadurch gekennzeichnet, dass** der axiale Abkühlungs-Temperaturgradient so vorgesehen wird, dass der axiale Quotient zwischen dem axialen Abkühlungs-Temperaturgradienten und dem axialen Züchtungs-Temperaturgradienten in jedem 1 cm$^3$ großen Teilvolumen innerhalb des mindestens einen SiC-Volumeneinkristalls (20; 24; 29; 33, 34) höchstens den axialen Vergleichswert hat.

4. Verfahren nach einem der vorhergehenden Ansprüche, **dadurch gekennzeichnet, dass** der axiale Abkühlungs-Temperaturgradient so vorgesehen wird, dass er mindestens 2 K/cm, und insbesondere höchstens 6 K/cm beträgt.

5. Verfahren nach einem der vorhergehenden Ansprüche, **dadurch gekennzeichnet, dass** während der Temperungs-Abkühlphase ein senkrecht zu der zentralen Kristallmittenlängsachse (14) gemessener radialer Abkühlungs-Temperaturgradient innerhalb des mindestens einen SiC-Volumeneinkristalls (20; 24; 29; 33, 34) vorgesehen wird, und ein radialer Quotient zwischen dem radialen Abkühlungs-Temperaturgradienten und einem am Ende der vorangegangenen Züchtungsphase innerhalb des mindestens einen aufgewachsenen SiC-Volumeneinkristalls (20; 24; 29; 33, 34) herrschenden und ebenfalls senkrecht zu der zentralen Kristallmittenlängsachse (14) gemessenen radialen Züchtungs-Temperaturgradienten höchstens einen radialen Vergleichswert von 0,4, und insbesondere höchstens einen radialen Vergleichswert von 0,3, hat.

6. Verfahren nach Anspruch 5, **dadurch gekennzeichnet, dass** der radiale Abkühlungs-Temperaturgradient so vorgesehen wird, dass der radiale Quotient zwischen dem radialen Abkühlungs-Temperaturgradienten und dem radialen Züchtungs-Temperaturgradienten in jedem 1 cm$^3$ großen Teilvolumen innerhalb des mindestens einen SiC-Volumeneinkristalls (20; 24; 29; 33, 34) höchstens den radialen Vergleichswert hat.

7. Verfahren nach Anspruch 5 oder 6, **dadurch gekennzeichnet, dass** der radiale Abkühlungs-Temperaturgradient so vorgesehen wird, dass er mindestens 0,25 K/cm, und insbesondere höchstens 2 K/cm beträgt.

8. Verfahren nach einem der vorhergehenden Ansprüche, **dadurch gekennzeichnet, dass** für den mindestens einen SiC-Volumeneinkristall (20; 24; 29; 33, 34) eine längs der zentralen Kristallmittenlängsachse (14) gemessene zentrale Kristalllänge von 30 mm bis 60 mm, insbesondere von 35 mm bis 50 mm, vorgesehen wird.

9. Verfahren nach einem der vorhergehenden Ansprüche, **dadurch gekennzeichnet, dass** nach Abschluss der Züchtungsphase als Maßnahme zur Reduzierung von Spannungen innerhalb des zuvor gezüchteten mindestens einen SiC-Volumeneinkristalls (20; 24; 29; 33, 34) die vorher verwendete Züchtungsanordnung (19; 23; 28; 32) verändert wird, indem eine zusätzliche Abdeckung (21; 25; 30; 42) stirnseitig benachbart zu einer den Züchtungstiegel (3; 36) umgebenden Züchtungsisolation (10; 40) platziert wird.

10. Verfahren nach Anspruch 9, **dadurch gekennzeichnet, dass** die zusätzliche Abdeckung (21; 30; 42) unmittelbar an die Züchtungsisolation (10; 40) angrenzend platziert wird.

11. Verfahren nach Anspruch 9, **dadurch gekennzeichnet, dass** die zusätzliche Abdeckung (25) beabstandet von der Züchtungsisolation (10) platziert wird, und ein axialer Abstand (27) zu der Züchtungsisolation (10) insbesondere zwischen 1 mm und 10 mm liegt.

12. Verfahren nach einem der Ansprüche 9 bis 11, **dadurch gekennzeichnet, dass** eine Ausgestaltung der zusätzlichen Abdeckung vorgesehen wird, bei der die zusätzliche Abdeckung (30; 42) eine zentrale axial durch die zusätzliche Abdeckung (30; 42) vollständig hindurchgehende Abdeckungsaussparung (31; 43) hat, und die zentrale Abdeckungsaussparung (31; 43) eine Querschnittsfläche hat, deren Quotient zu einer Querschnittsfläche einer stirnseitig in der Züchtungsisolation (10; 40) vorhandenen zentralen Isolationsaussparung (17; 41) insbesondere zwischen 0,1 und 0,3 liegt.

13. Verfahren nach einem der Ansprüche 9 bis 12, **dadurch gekennzeichnet, dass** eine Ausgestaltung der zusätzlichen Abdeckung vorgesehen wird, bei der die zusätzliche Abdeckung mindestens zwei axial durch die zusätzliche Abdeckung vollständig hindurchgehende Abdeckungsaussparungen hat, und jede Abdeckungsaussparung eine zugehörige Querschnittsfläche hat, wobei ein Quotient der Summe der Querschnittsflächen aller Abdeckungsaussparungen und der Querschnittsfläche der stirnseitig in der Züchtungsisolation vorhandenen zentralen Isolationsaussparung insbesondere zwischen 0,1 und 0,3 liegt.

14. Verfahren nach einem der vorhergehenden Ansprüche, **dadurch gekennzeichnet, dass** zwischen der Züchtungsphase und der Temperungs-Abkühlphase eine Temperungs-Haltephase durchgeführt wird, während der eine Temperungs-Haltetemperatur eingestellt wird, die mindestens so groß ist wie die während der Züchtungsphase eingestellte Züchtungstemperatur und insbesondere höchstens 250°C höher als die Züchtungstemperatur ist.

15. Einkristalliner SiC-Grundkörper (45) hergestellt aus einem sublimationsgezüchteten SiC-Volumeneinkristall (20; 24; 29; 33, 34) und bestimmt zum Heraustrennen mehrerer einkristalliner SiC-Substrate aus dem einkristallinen SiC-Grundkörper (45), wobei

a) der einkristalline SiC-Grundkörper (45) eine Form hat, die zumindest in einem Teilbereich die eines Kreiszylinders ist,, und
b) ein an der oberen Stirnseite (47) aus dem einkristallinen SiC-Grundkörper (45) heraustrennbares oberes einkristallines SiC-Substrat (48) eine obere Basalebenenversetzungsdichte und ein an der unteren Stirnseite (49) aus dem einkristallinen SiC-Grundkörper (45) heraustrennbares unteres einkristallines SiC-Substrat (50) eine untere Basalebenenversetzungsdichte aufweist, wobei sich die obere Basalebenenversetzungsdichte und die untere Basalebenenversetzungsdichte um höchstens 25 % voneinander unterscheiden.

1 8 17 (grad T)ax_zücht (grad T)rad_zücht

7

2

16

9

13

3

12

15

18

5

11 6 14 4 10

Fig. 1

Fig. 2

Fig. 3

Fig. 4

Fig. 5

Fig. 6

Nummer der Anmeldung

EP 25 15 2093

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 7 767 022 B1 (GUPTA AVINASH K [US] ET AL) 3. August 2010 (2010-08-03) | 1-8,14, 15 | INV. C30B23/00 |
| Y | * Abbildung 2 *<br>* Spalte 10, Zeile 34 - Spalte 11, Zeile 2 * | 9-13 | C30B23/06<br>C30B29/36 |
| | ----- | | |
| X | US 2018/282902 A1 (NAKABAYASHI MASASHI [JP]) 4. Oktober 2018 (2018-10-04)<br>* Beispiel comparative 1 *<br>* Tabelle 5 * | 15 | |
| | ----- | | |
| Y | US 9 340 898 B2 (CHEN XIAOLONG [CN]; WANG BO [CN] ET AL.) 17. Mai 2016 (2016-05-17)<br>* Abbildungen 2-7 *<br>* Spalte 5, Zeile 64 - Spalte 6, Zeile 59 * | 9-13 | |
| | ----- | | |
| A | US 2016/083865 A1 (SAKURADA TAKASHI [JP] ET AL) 24. März 2016 (2016-03-24)<br>* Abbildungen 1-9 *<br>* Absätze [0040] - [0042], [0045] - [0047], [0054], [0058] * | 1-15 | |
| | ----- | | |

**RECHERCHIERTE SACHGEBIETE (IPC)**

C30B

Der vorliegende Recherchenbericht wurde für alle Patentansprüche erstellt

| Recherchenort | Abschlußdatum der Recherche | Prüfer |
|---|---|---|
| Den Haag | 4. Juni 2025 | Schmitt, Christian |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 25 15 2093

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

04-06-2025

| Im Recherchenbericht angeführtes Patentdokument | Datum der Veröffentlichung | Mitglied(er) der Patentfamilie | Datum der Veröffentlichung |
|---|---|---|---|
| US 7767022 B1 | 03-08-2010 | KEINE | |
| US 2018282902 A1 | 04-10-2018 | CN 108138359 A | 08-06-2018 |
| | | JP WO2017057742 A1 | 19-07-2018 |
| | | US 2018282902 A1 | 04-10-2018 |
| | | WO 2017057742 A1 | 06-04-2017 |
| US 9340898 B2 | 17-05-2016 | CN 102534805 A | 04-07-2012 |
| | | EP 2653591 A1 | 23-10-2013 |
| | | JP 5450895 B2 | 26-03-2014 |
| | | JP 2013529175 A | 18-07-2013 |
| | | US 2013269598 A1 | 17-10-2013 |
| | | WO 2012079439 A1 | 21-06-2012 |
| US 2016083865 A1 | 24-03-2016 | KEINE | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 8865324 B2
- DE 102009048868 B4
- US 8449671 B2